# EUROPEAN PATENT SPECIFICATION

(11) **EP 2 187 526 B1**
(45) Date of publication and mention of the grant of the patent: **02.01.2013**
(21) Application number: 08168662.8
(22) Date of filing: 07.11.2008
(51) Int. Cl.: H03M 13/09

(54) **Fast computation of frame check sequences (FCS/CRC)**
Schnelle Berechnung von Rahmenprüfsequenzen (FCS/CRC)
Calcul rapide des séquences de contrôle de trame (FCS/CRC)

(43) Date of publication of application: 19.05.2010
(73) Proprietor: Alcatel Lucent, 75007 Paris (FR)
(72) Inventor: Post, Georg, 91620 La Ville du Bois (FR)
(74) Representative: Therias, Philippe

(56) References cited:
- EP-A- 1 087 534
- WO-A-01/61868
- WO-A-99/37030
- US-A1- 2005 268 209
- US-B1- 7 225 391
- HUBAUX D ET AL: "Word-parallel CRC computation on VLIW DSP" ELECTRONICS LETTERS, IEE STEVENAGE, GB, vol. 38, no. 2, 17 January 2002 (2002-01-17), pages 64-65, XP006017764 ISSN: 0013-5194

## Description

### Background of the invention

### Field of the invention

The present invention deals with a method for the computation of framecheck sequences A data packet that is formatted for the transport on Ethernet media is called a "frame" and the sequence of its last 32 bits, called the framecheck sequence (FCS), is computed from the preceding packet bits. It allows the detection of bit transmission errors with an extremely high probability. The generation of the FCS for each packet sent, as well as the check of the FCS for each packet received, is the task of the Media Access Controller (MAC) which is part of all Ethernet interfaces. The present invention will be described with reference to framecheck sequences of CRC (Cyclic Redundancy Check) type, but it applies also to any other types of framecheck sequences, of FEC (Forward Error Correction) type for example. The CRC is a manipulation on a bit string called the accumulator, where each incoming packet bit induces a shift/rotate of the accumulator, followed by an XOR logic operation on selected bit positions. It can mathematically be defined as computing the remainder of a division of the polynomial, represented by the packet content, by a fixed reference polynomial.

The invention relates generally to telecommunication networks, and more specifically to the detection of errors in the data payloads of data packets being handled by telecommunication devices. The data packets may be, for example, IP packets.Different documents dealing with this subject matter are known, such as the documents published as US 7225391,WO 01161868A,EP 1087534A, WO 99/37030andUS 2005/268209.

In a data telecommunication network, data are organized in frames; frames contain data packets which are forwarded from sources to destinations. The data packets may all have the same fixed size as do ATM (Asynchronous Transfer Mode) cells, or may have variable lengths as do IP (Internet Protocol) packets. Typically each frame includes a header which includes information about the data packet, including its destination and a data payload.

The network comprises a number of data transmission links which are connected to one another at nodes. In traversing the network, the data packets are passed along the transmission links from node to node. One or more more telecommunication devices are located in these nodes. These telecommunication devices may have, between themselves, various functions including directing received packets to the appropriate outgoing transmission link.

These telecommunication devices need tools which allow a reliable check of the integrity of the transferred data packets, both in emission or in reception. These tools can be of framecheck sequences type, such as CRC or FEC. A possible type of telecommunication device is an Ethernet Media Access Controller (MAC), which is a commutation packet node interfacing with Ethernet networks.

Future 100 Gbps Ethernet MACs need ultra-fast or highly parallel circuits to compute the framecheck sequences, such as a 32-bit CRC. But the clock used in these kinds of digital circuits will not change; typically, this clock works with a 200 MHz (MegaHerz) frequency. Moreover, for improved quality-of-transmission, forward-error-correction techniques might also be required, at the same bitrates of 100 Gbps and more.

As a consequence, in each clock cycle of a 200 MHz digital circuit, for example, a slice of 512 parallel bits of frame data needs to be processed, in order to meet the 100 Gbps data rate required.

As a consequence, a problem has been identified: because accelerating the clocks of existing designs is increasingly difficult, scaling to ever higher packet data rates - while the underlying silicon no longer improves - means that the digital circuits need more and more parallelism while keeping the clock frequency limited. But existing CRC computation circuits do not yet achieve the 100 Gbps target speed of packet processing. They use a mix of sequential and combinatorial processing but have not demonstrated a method to increase the parallelism to arbitrary width.

An object of the invention is thus to solve the above-mentioned problem.

### Summary of the invention:

To this end, the invention proposes a method for the computation of framecheck sequences where the latency from the arrival of the last slice of a frame to the delivery of the CRC result (when CRC is the chosen example of framecheck sequences) can be a constant and optimized - that means less than in the previous method used - delay of a predetermined number of clock cycles of a considered digital circuit. To achieve this aim, the used digital circuit accepts a new slice of data bits in every cycle of its internal clock. According to the invention, some partial CRC values are calculated in parallel for groups of data words of different slices of the frame. These partial CRC values are computed on some subsequent slices of the multi-slice frame, and the partial results are combined in a tree topology and an output accumulation register at the full clock rate of the digital circuit used.

In order to get the partial CRC values, the used registers are organised in a tree consisting in a set of pipelines in order to optimise the degree of parallelism of the considered digital circuit; then, the partial CRC values are processed ("combined") in a small number of combinatorial steps. The "root" of the tree is the output point where the "accumulator" register delivers the final result. The "leaves" of the tree are the input points where successive slices of the frame enter the system for parallel processing. The "intermediate nodes" of the tree are points where pairs of partial results are combined. The type of elementary logic for the kinds of CRC considered can always be reduced to lookup tables and Xor operations. A wide variety of tree topologies may be used. All compromises between space and processing time can be realised with flexibility.

The invention therefore relates to a method for the computation of framecheck sequences associated with a payload, formed by data packets, of a frame of data to be transmitted in a telecommunication network, said communication network comprising nodes with telecommunication devices having an internal clock, characterized in that the method comprises the different steps consisting in:
- dividing said data packets in a plurality of different words;
- defining different groups of words, each group being formed by a predetermined number of words, each word being contained in one and only one group;
- defining different slices, each slice being formed by a predetermined number of groups, each group being contained in one and only one slice;
- at a first clock cycle of the clock, transmitting simultaneously the first words of the different groups of a first slice in first stages of different logic boxes of said telecommunication device, each logic box receiving then one and only one word; computing said transmitted words with a start value to generate intermediate values ;
- at a following clock cycle of the clock, transmitting simultaneously the second words of the different groups of a first slice into the second stages of different logic boxes; computing said transmitted words with last intermediate values generated to generate new intermediate values, each word being computed in a given logic box with the last intermediate value generated by said first stage of said given logic box ;
- transmitting simultaneously the first words of the different groups of a second slice into the first stages of different logic boxes of said devices, proceeding with said first words of the different groups of a second slice like at the first clock cycle;
- repeating, at each following clock cycle of the clock, the previous steps until all the words of each slice have been transmitted in all the stages of the different logic boxes;
- combining the new intermediate values of all logic boxes to generate a result of the framecheck sequence.

In a particular example, the new intermediate values are combined by pairs.

The method of the invention may have other features, which may be used separately or in combination, and in particular:
- the different slices are formed by a constant number of words, each word being formed by a constant number of bits.
- the framecheck sequence is of CRC type.
- the framecheck sequence is of FEC type.
- said logic bloxes are of lookup tables type, for computing or combining by pairs.
- said logic blocks boxes are of bit-wise Xor logic gates type, for computing or combining by pairs.
- said step consisting in computing the new intermediate values to generate a result of the framecheck sequence comprises the different operations consisting in:

- combining, at a given clock cycle, two first intermediate values to generate a transitional value;
- combining, at each following clock cycle of the clock, the transitional value generated with a following new intermediate value;
- repeating, at each following clock cycle of the clock, the previous operation until each new intermediate value has been combined with a transitional value generated.
- said step consisting in computing the new intermediate values to generate a result of the framecheck sequence comprises the different operations consisting in:

- combining two by two, at a given clock cycle, said new intermediate values to generate some transitional values;
- combining two by two, at each following clock cycle of the clock, the transitional values to generate new transitional values;
- repeating, at each following clock cycle of the clock, the previous operation until there is still only one new transitional value.
- said telecommunication device is of Ethernet MAC type.

Other features and advantages of the invention will become apparent on reading the following detailed description and examining the appended drawings. The appended drawings constitute part of the description of the invention as well as contributing to the definition of the invention, if necessary.

### Brief description of the drawings:

Figure 1 shows a pipeline tree circuit for an example of computation of framecheck sequences according to the invention ;
Figure 2 is a diagram illustrating a first example according to the invention to combine the pipeline tree circuit of figure 1 ;
Figure 3 is a diagram illustrating a second example according to the invention to combine the pipeline tree circuit of figure 1.

### Detailed description of preferred embodiments:

Further characteristic features and advantages of the invention are set out in the following description. The following example deals with a 32-bit CRC on 128 input bits per clock. It is illustrated also with the following table:

| | | | | |
|---|---|---|---|---|
| (L1) | q0=f0{w0,start} | q4=f4{w4,start} | q8=f8{w8,start} | qc=fc{wc,start} |
| (L2) | q1=f1{w1,q0} | q5=f5{w5,q4} | q9=f9{w9,q8} | qd=fd{wd,qc} |
| (L3) | q2=f2{w2,q1} | q6=f6{w6,q5} | qa=fa{wa,q9} | qe=fe{we,qd} |
| (L4) | q3=f3{w3,q2} | q7=f7{w7,q6} | qb=fb{wb,qa} | qf=ff{wf,qe} |
| (L5) | | qq0=ff0{q3,q7} | | |
| (L6) | | | qq1=ff1{qq0,qb} | |
| (L7) | | | | qq2=ff2{qq1,qf} |
| (L8) | [Accumulator] | | | q =fff{q,qq2} |

The above sequential table is proposed to compute a CRC result on a slice of 16 bytes, that means 128 bits, {w0,w1,w2... wf} where each 'w' symbol is a byte and each 'q' symbol is a 32-bit word. The input slice has 16 words (of size 8 bits) and these words come in 4 groups, namely {w0...w3}, {w4...w7}, {w8...xb}, {wc...wf}. Each one of the groups is processed in a different logic box, according to one of the four columns of the table. In each logic box, there are four stages (L1) (L2) (L3) (L4) for the sequential processing of the four successive words of a group.

The four partial logic boxes use the same fixed 32-bit start value called 'start' and deliver the intermediate values q3, q7, qb, qf after 4 clock cycles. After 3 more clock cycles, these 4 intermediate values are combined to the transitional values qq0 qq1 qq2. Finally, the last transitional value is combined with the final value q, which is called the 'accumulator'. In any new clock cycle, the next 128 bits of the packet are fed into the subcircuit (entry point of the pipeline). At the same time, the accumulator receives the contribution to the result of the 128-bit input part that came 8 cycles ago. Whatever the total length of the packet, the result is available with a constant pipeline delay of 8 cycles.

On the above table, f<n> corresponds to any combinatorial function f of the following type, where XOR is the bit-wise exclusive-or operator:
- if x is a string of n1 bits, then y = f(x) is a string of n2 bits
- if y1 = f(x1) and y2 = f(x2), then (y1 XOR y2) = f(x1 XOR x2)

Implementation of such a function can be flexibly optimized: either for speed (large lookup tables, no logic gates) or for small silicon area (small lookup tables, cascades of Xor gates).

For example, suppose n1 = n2 = 16 so that x and y are 16-bit words. A read-only memory M of 65536 words of 16 bits would be a speed-optimal implementation of any function: y = f(x) = M[x] . With the postulated property related to XOR operations, an alternative implementation is possible, with two read-only memories M1 and M2 of only 256 words of 16 bits. If x = (u,v) has the high and low bytes u and v, respectively, then y = f(x) = M1[u] XOR M2[v]. Memories are much smaller, but there are XOR gates which cost processing time. More generally, the string x can be split into any number of pieces, each piece can be the address of a lookup-table memory, such that f(x) is the multiple XOR on all lookup results.

It can be generally asserted that all the combinatorial functions involved, in the continuation and propagation of CRC partial results, have the desired property that arbitrary XOR decompositions are possible. This is because the bit-wise XOR represents the "addition" of polynomials, and the combinatorial functions of the type f<n> represent "remainders" of a division by a reference polynomial.

Each one of the 16 functions fx{w,q} works identically and computes a partial CRC result (q) by the bit size of data word w.

### Example 1:

- w has 16 bits, q has 32 bits
- z := w XOR {the rightmost half of q}
- lookup four 32-bit partial results a, b, c, d; using the four nibbles (4-bit substrings) of z (these are 4 tables of 16 entries)
- fx := a XOR b XOR c XOR d XOR {q, shifted right by 16 bits}

### Example 2:

- w has 8 bits, q has 32 bits
- z := w XOR {the rightmost byte of q}
- lookup four 32-bit partial results a, b using the two nibbles (4-bit substrings) of z (these are 2 tables of 16 entries)
- fx := a XOR b XOR {q, shifted right by 8 bits}

The combination functions ff0 ... ff3 are propagation results along partial CRC results of "q" type. They take two 32-arguments a,b and can be implemented as follows :
ffx{a,b} := Lookup(32) [a] XOR b (Example 1)

Here Lookup(d) means that the partial CRC has to be "propagated" over a distance of d bits. Such tables can be implemented as four 32-bit tables with byte addressing and Xor operators:
Lookup(d) [a = {b0,b1,b2,b3} ] = L0{b0} XOR L1{b1} XOR L2{b2} XOR L3{b3}

Here a is a 32-bit word and b0, b1, b2, b3 are the four 8-bit words (bytes) which represent the bits of a, from highest to lowest positions.

Finally, the accumulator, which is the 32-bit register that holds the final result at the end of the calculation, is updated with a feedback operation, involving a combination function fff of the same form:
fff(a,b) := Lookup(128) [a] XOR b

Here, the part before the XOR operator may be implemented, with low memory consumption as indicated above, using four lookup-table ROMs of 256 words (addressed with the four component bytes of a), followed by three XOR operations.

The lines (L1) to (L8) represent groups of combinatorial units which work in parallel. From one line to the next, data are transferred via registers. Data propagate from one line to the next in exactly one clock cycle of the considered digital circuit.

For example, at time 0 all sixteen input word {w0...wf}, which results from the segmentation of a data packet of a frame, and fixed start values (four start values in this example), are available in the first line. On Line 1, four of the words (w0, w4, w8, wc) are used to compute 4 intermediate values, the other words are propagated to the next line, thanks to an operation of shift register type.

On line 4, that means after 4 clock cycles, all words composing that data packet are used up and intermediate results {q3,q7,qb,qf} are made available.

In the next three steps, the intermediate results are combined to form the last transitional result of this processing tree, called qq2. In the final step, qq2 is combined with an accumulator that will hold the end result, called q.

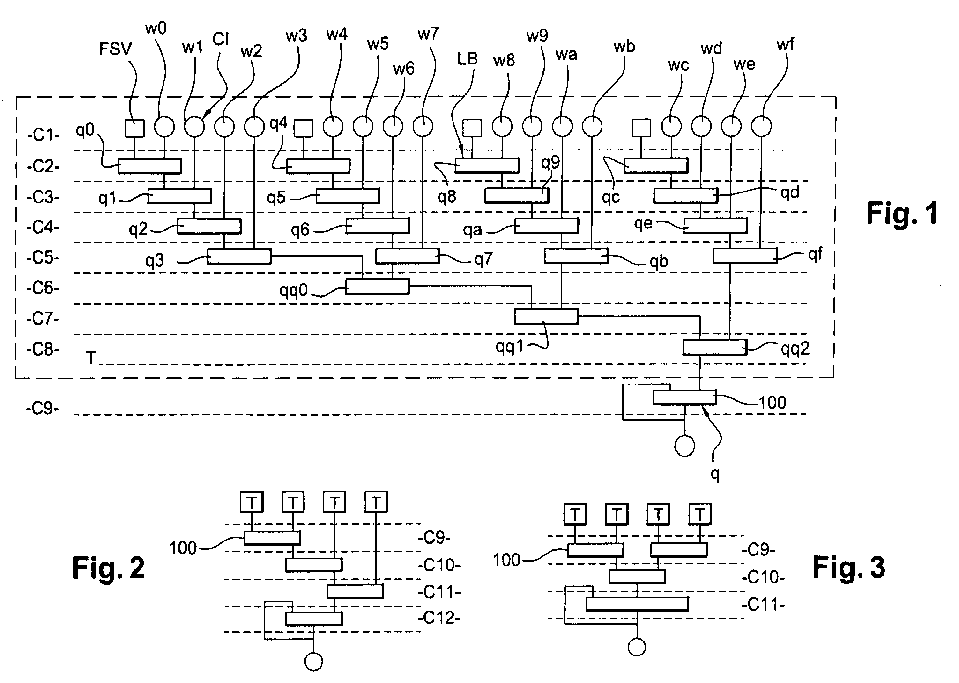

Figure 1 shows high-level schematics of a pipeline tree circuit for this CRC computation, by slices of 128 bits. Each horizontal dotted line, referenced C1 to C9, represents a clocked register operation. Each dotted line Ci corresponds to the line Li of the above table. All boxes contain only combinatorics (for example, lookup table assemblies in FPGAs (Field-Programmable Gate Array)). Circuit inputs Cl are represented as circles, fixed start values FSV as squares.

Processing goes from top to bottom: the inputs lines to a logic box LB are on its top, all other lines are its outputs. The pipeline tree which is called T is the part inside the dashed box. It feeds a 32-bit accumulator 100 that processes the result for frames composed of multiple bit slices. The reset circuitry that initiates a new frame is not shown in the figure.

The whole structure is a multi-thread pipeline and has the topology of a tree of pipelines. It can receive one slice of 128 bits per cycle and produce CRC results in the accumulator with a latency of 8 cycles.

To produce CRCs with 512-bit slices, four of the above trees are operated in parallel and interconnected with a final four-step propagation cascade of transitional values, similar to the one producing {qq0,qq1,qq2,q}.

Figures 2 and 3 show two possible ways to combine the sub-trees of type T in such a larger tree. The pure binary version (shown in Figure 3) may save one clock cycle, with clock cycle referenced C9, C10 and C11, whereas in figure 2, a thirteenth clock cycle C13 is necessary. In another implementation of the invention, a strict binary version of tree T, not shown, might also be proposed, for ultimate acceleration.

The whole pipeline tree, outlined in figure 3 for processing 512 bits per clock cycle, has 64 "leaves", that means circuit inputs charging a substring of 8 bits at its top. It outputs the CRC results in its root, the accumulator at the bottom. The total expected latency is 12 clock cycles corresponding to 60 nanoseconds, according to the depth of the tree.

The type of circuit can be programmed for any kind of polynomial division and is not specifically optimized for the standard CRC coefficients. Use is possible in forward-error-correction applications.

With the tree structure of pipelines, the degree of parallelism can be increased in a very flexible way. If in the future packet data rates like 400 Gbps become feasible, the tree method of extending then parallelism might still be useful. Many different tree topologies might be envisioned.

An advantage of the tree topologies for circuit design is that the physical data path lengths on the circuit can be kept short, because all functions require only local inputs. There is no feedback with long wiring paths.

## Claims

1. Method for the computation of framecheck sequences associated with a payload, formed by data packets, of a frame of data to be transmitted in a telecommunication network, said communication network comprising nodes with telecommunication devices having an internal clock, **characterized in that** the method comprises the different steps consisting in:
- dividing said data packets in a plurality of different words;
- defining different groups of words, each group being formed by a predetermined number of words, each word being contained in one and only one group;
- defining different slices, each slice being formed by a predetermined number of groups, each group being contained in one and only one slice;
- at a first clock cycle of the clock, transmitting simultaneously the first words of the different groups of a first slice into first stages of different logic boxes of said telecommunication device, each logic box receiving then one and only one word; computing said transmitted words with a start value to generate intermediate values ;
- at the following clock cycle of the clock, transmitting simultaneously the second words of the different groups of a first slice into the second stages of different logic boxes; computing said transmitted words with last intermediate values generated to generate new intermediate values, each word being computed in a given logic box with the last intermediate value generated by said first stage of said given logic box ;
- transmitting simultaneously the first words of the different groups of a second slice into the first stages of different logic boxes of said devices, proceeding with said first words of the different groups of a second slice like at the first clock cycle;
- repeating, at each following clock cycle of the clock, the previous steps until all the words of each slice have been transmitted into all the stages of the different logic boxes;
- combining the new intermediate values of all logic boxes to generate a result of the framecheck sequence.

2. The method according to claim 1 **characterized in that** the different slices are formed by a constant number of words, each word being formed by a constant number of bits.

3. The method according to one of the previous claims **characterized in that** the framecheck sequence is of CRC type.

4. The method according to one of claims 1 or 2 **characterized in that** the framecheck sequence is of FEC type.

5. The method according to one of the previous claims **characterized in that** said logic boxes are of lookup tables type, for computing or combining by pairs.

6. The method according to one of the claims 1 to 4 **characterized in that** said logic boxes, are of Xor logic gates type for computing or combining by pairs.

7. The method according to one of the previous claims **characterized in that** said step consisting in combining the new intermediate values to generate a result of the framecheck sequence comprises the different operations consisting in:
- combining, at a given clock cycle, two first intermediate values to generate a transitional value;
- combining, at each following clock cycle of the clock, the transitional value generated with a following new intermediate value;
- repeating, at each following clock cycle of the clock, the previous operation until each new intermediate value has been combined with a transitional value generated.

8. The method according to one of the claims 1 to 6 **characterized in that** said step consisting in combining the new intermediate values to generate a result of the framecheck sequence comprises the different operations consisting in:
- combining two by two, at a given clock cycle, said new intermediate values to generate some transitional values;
- combining two by two, at each following clock cycle of the clock, the transitional values to generate new transitional values;
- repeating, at each following clock cycle of the clock, the previous operation until there is still only one new transitional value.

9. The method according to one of the previous claims **characterized in that** said telecommunication device is of Ethernet MAC type.

## Patentansprüche

1. Verfahren zur Berechnung von mit Nutzdaten assoziierten Rahmenprüfzeichenfolgen, die von Datenpaketen gebildet werden, eines in einem Telekommunikationsnetzwerk zu übertragenden Datenrahmens, wobei das besagte Kommunikationsnetzwerk Knoten mit Telekommunikationsvorrichtungen, die einen internen Zeitgeber aufweisen, umfasst, **dadurch gekennzeichnet, dass** das Verfahren die folgenden verschiedenen Schritte umfasst:
- Aufteilen der besagten Datenpakete in eine Vielzahl von verschiedenen Wörtern;
- Definieren unterschiedlicher Gruppen von Wörtern, wobei jede Gruppe aus einer vorgegebenen Anzahl von Wörtern gebildet wird, wobei jedes Wort in einer, und ausschließlich einer Gruppe enthalten ist;
- Definieren unterschiedlicher Slices, wobei jedes Slice aus einer vorgegebenen Anzahl von Gruppen gebildet wird, wobei jede Gruppe in einem, und ausschließlich einem Slice enthalten ist;
- bei einem ersten Taktzyklus des Zeitgebers, gleichzeitiges Übertragen der ersten Wörter der unterschiedlichen Gruppen eines ersten Slice in die erste Stufen von unterschiedlichen Logikeinheiten der besagten Telekommunikationsvorrichtung, wobei jede Logikeinheit ein, und ausschließlich ein Wort empfängt; Berechnen der besagten übertragenen Wörter mit einem Startwert, um Zwischenwerte zu erzeugen;
- bei dem darauf folgenden Taktzyklus des Zeitgebers, gleichzeitiges Übertragen der zweiten Wörter der unterschiedlichen Gruppen eines ersten Slice in die zweiten Stufen von unterschiedlichen Logikeinheiten; Berechnen der besagten übertragenen Wörter mit den letzten erzeugten Zwischenwerten, um neue Zwischenwerte zu erzeugen, wobei jedes Wort in einer gegebenen Logikeinheit mit den von der ersten Stufe der besagten gegebenen Logikeinheit erzeugten letzten Zwischenwerten berechnet wird;
- gleichzeitiges Übertragen der ersten Wörter von unterschiedlichen Gruppen eines zweiten Slice in die ersten Stufen von unterschiedlichen Logikeinheiten der besagten Vorrichtungen, Fortfahren mit den besagten ersten Wörtern der unterschiedlichen Gruppen eines ersten Slice wie bei dem ersten Taktzyklus;
- Wiederholen, bei jedem nachfolgenden Taktzyklus, der vorstehenden Schritte, bis alle Wörter eines jeden Slice in alle Stufen der unterschiedlichen Logikeinheiten übertragen worden sind;
- Kombinieren der neuen Zwischenwerte aller Logikeinheiten, um ein Ergebnis der Rahmenprüfzeichenfolge zu erzeugen.

2. Verfahren nach Anspruch 1, **dadurch gekennzeichnet, dass** die unterschiedlichen Slices aus einer konstanten Anzahl von Wörtern gebildet werden, wobei jedes Wort aus einer konstanten Anzahl von Bits gebildet wird.

3. Verfahren nach einem der vorstehenden Ansprüche, **dadurch gekennzeichnet, dass** die Rahmenprüfzeichenfolge vom Typ CRC ist.

4. Verfahren nach einem der Ansprüche 1 oder 2, **dadurch gekennzeichnet, dass** die Rahmenprüfzeichenfolge vom Typ FEC ist.

5. Verfahren nach einem der vorstehenden Ansprüche, **dadurch gekennzeichnet, dass** die Logikeinheiten vom Typ Lookup-Tabelle für das Berechnen oder das paarweise Kombinieren sind.

6. Verfahren nach einem der Ansprüche 1 bis 4, **dadurch gekennzeichnet, dass** die Logikeinheiten vom Typ logische XOR-Gates für das Berechnen oder das paarweise Kombinieren sind.

7. Verfahren nach einem der vorstehenden Ansprüche, **dadurch gekennzeichnet, dass** der besagte Schritt des Kombinierens der neuen Zwischenwerte, um ein Ergebnis der Rahmenprüfzeichenfolge zu erhalten, die folgenden unterschiedlichen Vorgänge umfasst:
- Kombinieren, bei einem gegebenen Taktzyklus, von zwei ersten Zwischenwerten, um einen Übergangswert zu erhalten;
- Kombinieren, bei jedem folgenden Taktzyklus des Zeitgebers, des Übergangswertes mit einem folgenden neuen Zwischenwert;
- Wiederholen, bei jedem folgenden Taktzyklus des Zeitgebers, des vorherigen Vorgangs, bis jeder neue Zwischenwert mit einem erzeugten Übergangswert kombiniert worden ist.

8. Verfahren nach einem der Ansprüche 1 bis 6, **dadurch gekennzeichnet, dass** der besagte Schritt des Kombinierens der neuen Zwischenwerte, um ein Ergebnis der Rahmenprüfzeichenfolge zu erhalten, die folgenden unterschiedlichen Vorgänge umfasst:
- paarweises Kombinieren, bei einem gegebenen Taktzyklus, der besagten neuen Zwischenwerte, um einige Übergangswerte zu erhalten;
- paarweises Kombinieren, bei jedem folgenden Taktzyklus des Zeitgebers, der Übergangswerte, um neue Übergangswerte zu erhalten;
- Wiederholen, bei jedem folgenden Taktzyklus des Zeitgebers, des vorherigen Vorgangs, bis nur noch ein neuer Übergangswert übrig bleibt.

9. Verfahren nach einem der vorstehenden Ansprüche, **dadurch gekennzeichnet, dass** die besagte Telekommunikationsvorrichtung vom Typ Ethernet MAC ist.

## Revendications

1. Procédé pour le calcul de séquences de contrôle de trame associées à des données utiles, formées par des paquets de données, d'une trame de données à transmettre dans un réseau de télécommunication, ledit réseau de communication comprenant des noeuds avec des dispositifs de télécommunication présentant une horloge interne, **caractérisé en ce que** le procédé comprend les différentes étapes suivantes :
- diviser lesdits paquets de données en une pluralité de mots différents;
- définir différents groupes de mots, chaque groupe étant formé par un nombre prédéterminé de mots, chaque mot étant contenu dans un seul groupe ;
- définir différentes tranches, chaque tranche étant formée par un nombre prédéterminé de groupes, chaque groupe étant contenu dans une seule tranche ;
- à un premier cycle d'horloge de l'horloge, transmettre simultanément les premiers mots des différents groupes d'une première tranche dans les premiers étages de différents boîtiers logiques dudit dispositif de télécommunication, chaque boîtier logique recevant alors un seul mot ; calculer lesdits mots transmis avec une valeur de départ pour générer des valeurs intermédiaires ;
- au cycle d'horloge suivant de l'horloge, transmettre simultanément les deuxièmes mots des différents groupes d'une première tranche dans les deuxièmes étages de différents boîtiers logiques ; calculer lesdits mots transmis avec les dernières valeurs intermédiaires générées pour générer de nouvelles valeurs intermédiaires, chaque mot étant calculé dans un boîtier logique donné avec la dernière valeur intermédiaire générée par ledit premier étage dudit boîtier logique donné ;
- transmettre simultanément les premiers mots des différents groupes d'une deuxième tranche dans les premiers étages des différents boîtiers logiques desdits dispositifs, procéder avec lesdits premiers mots des différents groupes d'une deuxième tranche comme au premier cycle d'horloge ;
- répéter, à chaque cycle d'horloge suivant de l'horloge, les étapes précédentes jusqu'à ce que tous les mots de chaque tranche soient transmis dans tous les étages des différents boîtiers logiques ;
- combiner les nouvelles valeurs intermédiaires de tous les boîtiers logiques pour générer un résultat de la séquence de contrôle de trame.

2. Procédé selon la revendication 1 **caractérisé en ce que** les différentes tranches sont formées par un nombre constant de mots, chaque mot étant formé par un nombre constant de bits.

3. Procédé selon l'une des revendications précédentes **caractérisé en ce que** la séquence de contrôle de trame est de type CRC.

4. Procédé selon l'une des revendications 1 ou 2 **caractérisé en ce que** la séquence de contrôle de trame est de type FEC.

5. Procédé selon l'une des revendications précédentes **caractérisé en ce que** lesdits boîtiers logiques sont de type tables de consultation, pour calculer ou combiner par paires.

6. Procédé selon l'une des revendications 1 à 4 **caractérisé en ce que** lesdits boîtiers logiques sont de type X ou portes logiques pour calculer ou combiner par paires.

7. Procédé selon l'une des revendications précédentes **caractérisé en ce que** ladite étape consistant à combiner les nouvelles valeurs intermédiaires pour générer un résultat de la séquence de contrôle de trame comprend les différentes opérations suivantes :
- combiner, à un cycle d'horloge donné, deux premières valeurs intermédiaires pour générer une valeur de transition ;
- combiner, à chaque cycle d'horloge suivant de l'horloge, la valeur de transition générée avec une nouvelle valeur intermédiaire suivants ;
- répéter, à chaque cycle d'horloge suivant de l'horloge, l'opération précédente jusqu'à ce que chaque nouvelle valeur intermédiaire soit combinée avec une valeur de transition générée.

8. Procédé selon l'une des revendications 1 à 6 **caractérisé en ce que** ladite étape consistant à combiner les nouvelles valeurs intermédiaires pour générer un résultat de la séquence de contrôle de trame comprend les différentes opérations suivantes :
- combiner deux par deux, à un cycle d'horloge donné, lesdites nouvelles valeurs intermédiaires pour générer certaines valeurs de transition ;
- combiner deux par deux, à chaque cycle d'horloge suivant de l'horloge, les valeurs de transition pour générer de nouvelles valeurs de transition ;
- répéter, à chaque cycle d'horloge suivant de l'horloge, l'opération précédente jusqu'à ce qu'il n'y ait plus qu'une seule nouvelle valeur de transition.

9. Procédé selon l'une des revendications précédentes **caractérisé en ce que** ledit dispositif de télécommunication est de type MAC Ethernet.
